# EUROPEAN PATENT APPLICATION

(11) **EP 4 201 903 A1**
(43) Date of publication of application: **28.06.2023**
(21) Application number: 22205195.5
(22) Date of filing: 03.11.2022
(51) Int. Cl.: C03C 15/00, C03C 17/06, C03C 17/36, C03C 23/00

(54) **PLATE-UP HYBRID STRUCTURES USING MODIFIED GLASS PATTERNING PROCESSES**

(30) Priority: 24.12.2021 US 202117561734
(71) Applicant: INTEL Corporation, Santa Clara, CA 95054 (US)
(72) Inventor: DOGIAMIS, Georgios C., Chandler, 85226 (US); KAMGAING, Telesphor, Chandler, 85249 (US); RAWLINGS, Brandon, Chandler, 85248 (US); PRABHU GAUNKAR, Neelam, Chandler, 85225 (US); STRONG, Veronica, Hillsboro, 97123 (US); ALEKSOV, Aleksandar, Chandler, 85286 (US)
(74) Representative: Goddar, Heinz J.

(57) **Abstract**

Embodiments disclosed herein include electronic packages and methods of forming such packages. In an embodiment, an electronic package comprises a core, where the core comprises glass. In an embodiment, a via opening is formed through the core. In an embodiment, the via opening has an aspect ratio (depth:width) that is approximately 5:1 or greater. In an embodiment, the electronic package further comprises a via in the via opening, where the via opening is fully filled.

## Description

### TECHNICAL FIELD

Embodiments of the present disclosure relate to electronic packages, and more particularly to electronic packages with glass cores with high aspect ratio vias formed with a plate-up process.

### BACKGROUND

As computing technology becomes more ubiquitous, there is a growing demand for low cost, pervasive sensing. In particular, chemical, temperature, pressure, and acceleration sensing is an area of strong interest. For example, current chemical sensors are often bulky and are always external components that must be attached to the SoC package or system board (and routed to the SoC). Similarly, accelerometers are an integral part of many of today's computing platforms such as tablets, smartphones, wearables, IoT, and even client devices like laptops. Most of those sensors are manufactured using silicon-based MEMS approaches, and packaged and assembled onto the package or board as a discrete part. Those sensor packages are typically tall (e.g., approximately 1mm or greater in height), which can be challenging to accommodate in certain platforms where a thin form factor is desired. Moreover, the sensor devices are manufactured at wafer-level using expensive materials (such as silicon) and require assembly after packaging, which adds to the overall system cost. Pressure sensors in particular are important for consumer mobile devices to monitor barometric pressure, and also have a wide range of applications (e.g., industrial equipment and facility monitoring, automotive systems, IoT, and mobile health monitoring).

In some systems glass cores are used in the package substrate. Glass cores can be patterned with a laser assisted etching process in order to make high aspect ratio via openings through the glass core. However, the high aspect ratio features are challenging to fill with conductive material. In some instances, the via openings are lined with a seed layer, and then plated. The plating within the via opening is a lateral plating that extends out from the sidewalls. Such plating operations may result in a seam being formed at the center of the via opening. In some instances, voids may also be present at the center of the via openings.

In addition to difficulties in integrating sensors into electronic systems and filling high aspect ratio features in glass cores, data transfer rates continue to increase. As more devices become interconnected and users consume more data, the demand on servers has grown at an incredible rate. Among others, these demands include increased data rates, switching architectures which require longer interconnects, and extremely cost and power competitive solutions. Electrical interconnects are becoming increasingly expensive and power hungry to support the required data rates. For example, to extend the reach of a cable or the given bandwidth on a cable, higher quality cables may need to be used and/or advanced equalization, modulation, and/or data correction techniques need to be employed. These solutions add power and latency to the system. For some distances and data rates required in proposed architectures, there is no viable electrical solution. Optical transmission over fiber is capable of supporting the required data rates and distances, but at a severe power and cost penalty, especially for short to medium distances (e.g., a few meters).

### BRIEF DESCRIPTION OF THE DRAWINGS

Figures 1A-1C are cross-sectional illustrations depicting a process for forming a via opening through a glass core with a laser assisted etching process, in accordance with an embodiment.
Figures 2A-2C are cross-sectional illustrations depicting a process for forming blind via openings into a glass core with a laser assisted etching process, in accordance with an embodiment.
Figures 3A-3C are cross-sectional illustrations depicting a process for forming a blind via opening into a glass core with a laser assisted etching process, in accordance with an embodiment.
Figures 4A-4D are cross-sectional illustrations depicting a process for forming suspended plates across blind openings into a glass core, in accordance with an embodiment.
Figure 5 is a plan view illustration of a plate that can span a blind opening into a glass core, in accordance with an embodiment.
Figures 6A is a cross-sectional illustration of an electronic structure with suspended plates over via openings in a glass core with a magnetic lid over the plates, in accordance with an embodiment.
Figure 6B is a cross-sectional illustration of an electronic structure with suspended plates over via openings in a glass core with a magnetic lid over the plates and a buildup layer below the glass core, in accordance with an embodiment.
Figure 6C is a cross-sectional illustration of an electronic structure with suspended plates over via openings in a glass core with a magnetic block in the glass core below the via openings, in accordance with an embodiment.
Figure 7 is a plan view illustration of a plate that can span a blind opening into a glass core with piezoelectric layers over the anchors, in accordance with an embodiment.
Figures 8A-8D are cross-sectional illustrations depicting a process for plating vias in a via opening through a glass core, in accordance with an embodiment.
Figures 9A-9E are cross-sectional illustrations depicting a process for plating vias in via openings with a bottom-up plating process, in accordance with an embodiment.
Figures 10A-10G are cross-sectional illustrations depicting a process for plating vias in via openings with a dielectric layer in the middle of the via, in accordance with an embodiment.
Figure 11 is a cross-sectional illustration of an electronic package with electromagnetic wave launchers in a glass core, in accordance with an embodiment.
Figure 12A is a perspective view illustration of the electromagnetic wave launcher, in accordance with an embodiment.
Figure 12B is a perspective view illustration of an array of electromagnetic wave launchers, in accordance with an embodiment.
Figure 13 is a cross-sectional illustration of an array of electromagnetic wave launchers with a vertical orientation, in accordance with an embodiment.
Figures 14A-14F are cross-sectional illustrations depicting a process of forming structures in a glass core, in accordance with an embodiment.
Figures 15A-15C are cross-sectional illustrations depicting a process of forming capacitors in a glass core, in accordance with an embodiment.
Figures 16A and 16B are plan view illustrations of serpentine traces over a cavity in a core, in accordance with an embodiment.
Figure 17 is a cross-sectional illustration of an electronic system, in accordance with an embodiment.
Figure 18 is a schematic of a computing device built in accordance with an embodiment.

### EMBODIMENTS OF THE PRESENT DISCLOSURE

Described herein are electronic packages with glass cores with high aspect ratio vias formed with a plate-up process, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, problems exist in several areas including: 1) integrating sensors into electronic systems; 2) filling high aspect ratio via openings in glass cores; and 3) providing cost and latency competitive interconnect architectures. In order to address these areas, embodiments disclosed herein utilize a laser assisted glass etching process. In one embodiment, the laser assisted glass etching process can be utilized to provide MEMS like fabrication on the glass core. For example, plates can be suspended over cavities formed into the glass in order to provide sensor structures. In another embodiment, high aspect ratio vias can be fully filled with a bottom up deposition process. For example, a conductive layer can be disposed over the surface of the glass core, and the via opening can be formed over the conductive layer. The via can then be plated up from the conductive layer instead of the sidewalls of the via opening. In yet another embodiment, mm-Wave or sub-THz signals can be launched with launcher architectures formed in the glass core. The launcher architectures may be fabricated in the glass core using laser assisted etching processes.

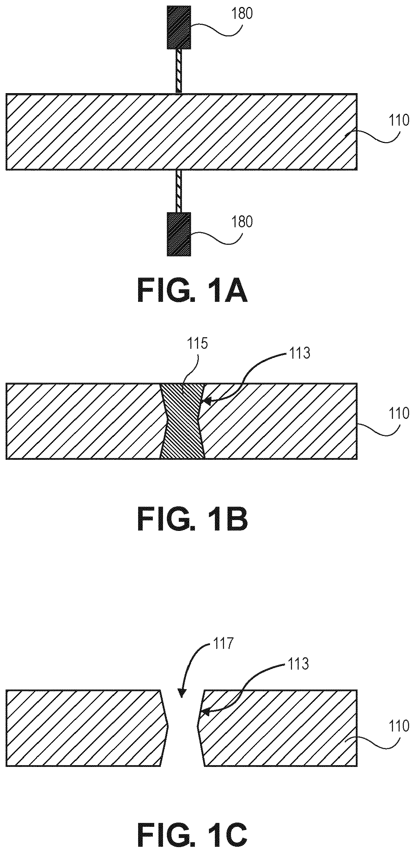

Referring now to Figures 1A-1C, a series of cross-sectional illustrations depicting a process for fabricating openings in a glass core 110 is shown, in accordance with an embodiment.

Referring now to Figure 1A, a cross-sectional illustration of a glass core 110 is shown, in accordance with an embodiment. In an embodiment, the glass core 110 may have a thickness that is between approximately 50µm and approximately 1,000µm. Though, it is to be appreciated that other thicknesses (larger or smaller) may also be used for the glass core 110. In an embodiment, a laser 180 is used to expose a region of the glass core 110. As shown in Figure 1A, the exposure may be made on both sides (i.e., the top surface of the glass core 110 and the bottom surface of the glass core 110). A single laser 180 may be used, or multiple lasers may be used. In an embodiment, the laser 180 is exposed over the glass core 110 at locations where via openings are desired.

Referring now to Figure 1B, a cross-sectional illustration of the glass core 110 after the laser 180 exposure is completed is shown, in accordance with an embodiment. As shown, the laser 180 exposure may result in the formation of exposed regions 115. In an embodiment, the glass core 110 may comprise a glass material that is able to be morphologically changed upon exposure to a laser 180. For example, the morphological change may result in the microstructure of the glass core 110 transforming to a crystalline structure from an amorphous structure. Accordingly, the exposed region 115 is shown with a different shading than the glass core 110.

In an embodiment, the laser 180 exposure may result in an exposed region 115 that has a tapered sidewall 113. In the instance where both sides of the glass core 110 are exposed (as is the case shown in Figure 1A), the exposed region 115 may have a double tapered profile. That is, widths of the exposed region 115 at a top surface of the glass core 110 and at a bottom surface of the glass core 110 may be wider than a width at a middle of the glass core 110. In some instances, such a sidewall 113 profile may be referred to as an hourglass shaped profile.

Referring now to Figure 1C, a cross-sectional illustration of the glass core 110 after the exposed region 115 is removed is shown, in accordance with an embodiment. In an embodiment, removal of the exposed region 115 may result in the formation of a via opening 117. The via opening 117 may pass entirely through a thickness of the glass core 110. In an embodiment, the via opening 117 may be a high aspect ratio via opening 117. As used herein a "high aspect ratio" may refer to an aspect ratio (depth:width) that is approximately 5:1 or greater, with the width being measured at a narrowest point through a thickness of the via opening 117. In other embodiments, the aspect ratio of the via opening 117 may be approximately 10:1 or greater, approximately 20:1 or greater, or approximately 50:1 or greater.

After the formation of the via opening 117, structures may be formed through and/or around the via opening 117 in order to provide desired structures, such as those described in greater detail below. For example, sensor architectures with a plate spanning across an end of the via opening 117 may be made in some embodiments. In other embodiments, vias without seams or voids may fill the via openings 117. In yet another embodiment, structures such as fins used for launching mm-wave or sub-THz signals may be formed in the via openings 117.

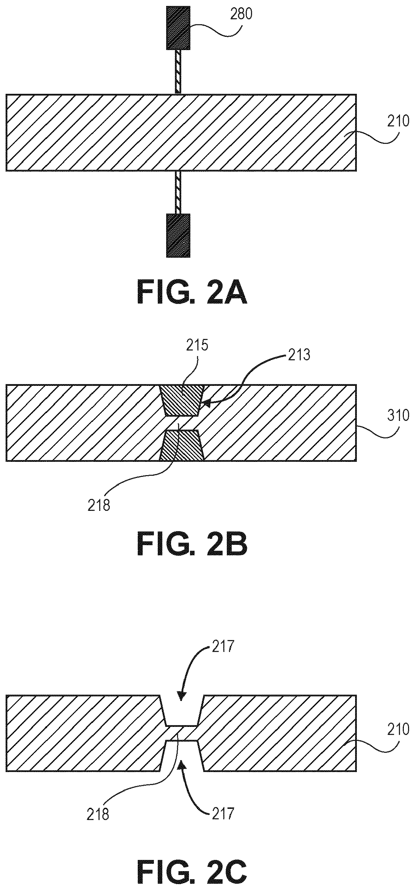

Referring now to Figures 2A-2C, a series of cross-sectional illustrations depicting a process for forming blind structures into a glass core 210 is shown, in accordance with an embodiment. Instead of forming an opening entirely through the glass core 210, structures that extend partially through a thickness of the core 210 are provided.

Referring now to Figure 2A, a cross-sectional illustration of a glass core 210 is shown, in accordance with an embodiment. In an embodiment, the glass core 210 may be substantially similar to the glass core 110 described in greater detail above. For example, the glass core 210 may have a thickness between approximately 50µm and approximately 1,000µm. In an embodiment, lasers 280 may expose portions of the glass core 210. In an embodiment, the laser 280 exposure in Figure 2A may be different than the laser 180 exposure in Figure 1A. For example, an intensity or duration of the laser 280 exposure may be less than the intensity or duration of the laser 180 exposure in Figure 1A.

Referring now to Figure 2B, a cross-sectional illustration of the glass core 210 after exposed regions 215 are formed is shown, in accordance with an embodiment. In an embodiment, the exposed regions 215 do not extend entirely through a thickness of the glass core 210. For example, a region 218 may be provided between the top exposed region 215 and the bottom exposed region 215. In some instances, the exposed regions 215 still include tapered sidewalls 213. Since the exposed regions 215 are formed from only a single side, the sidewalls 213 may only have a single taper. That is, the exposed regions 215 may not be hourglass shaped.

Referring now to Figure 2C, a cross-sectional illustration of the glass core 210 after the exposed regions 215 are removed to form openings 217 is shown, in accordance with an embodiment. In an embodiment, the exposed regions 215 may be removed with an etching process that is selective to the exposed regions 215 over the rest of the glass core 210. As shown, the openings 217 do not extend entirely through the glass core 210. In such embodiments, the openings 217 may be referred to as blind openings since they do not pass through the glass core 210. Blind openings can be used to form some structures described in greater detail below. For example, sensor structures that require a plate over a blind cavity can be formed in some embodiments.

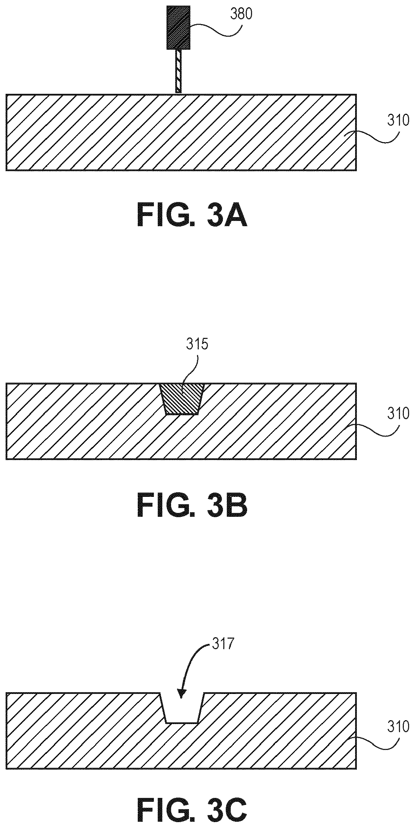

Referring now to Figures 3A-3C, a series of cross-sectional illustrations depicting a process for forming a blind opening 317 is shown, in accordance with an embodiment.

Referring now to Figure 3A, a cross-sectional illustration of a glass core 310 is shown, in accordance with an embodiment. In an embodiment, the glass core 310 may be substantially similar to the glass cores 110 and 210 described in greater detail above. For example, the glass core 310 may have a thickness between approximately 50µm and approximately 1,000µm. In an embodiment, a laser 380 may be used to expose a surface of the glass core 310. In contrast to embodiments described in greater detail above, the laser 380 exposure may only be provided on a single surface of the glass core 310.

Referring now to Figure 3B, a cross-sectional illustration of the glass core 310 after the laser exposure to form an exposed region 315 is shown, in accordance with an embodiment. In an embodiment, the exposed region 315 may be a region that has a morphology change compared to the rest of the glass core 310. For example, the morphology change may be the transition from an amorphous structure to a crystalline structure. In an embodiment, the exposed region 315 may not extend entirely through a thickness of the glass core 310. That is, the exposed region 315 may be suitable for forming blind structures.

However, it is to be appreciated that in some embodiments, a laser 380 exposure on a single surface of the glass core 310 can be used to form an exposed region 315 that extends through an entire thickness of the glass core 310. That is, it is not necessary to use an exposure on both sides of the glass core 310 in order to form through core structures. In such an embodiment, the sidewall profile of the exposed region 315 may have a single taper, instead of the hour-glass shaped taper shown in Figure 1B.

Referring now to Figure 3C, a cross-sectional illustration of the glass core 310 after the exposed region 315 is removed is shown, in accordance with an embodiment. In an embodiment, the removal of the exposed region 315 may result in an opening 317 being formed into the surface of the glass core 310. In an embodiment, the opening 317 may be a blind opening. Blind openings can be used to form some structures described in greater detail below. For example, sensor structures that require a plate over a blind cavity can be formed in some embodiments. In other embodiments, the opening 317 may pass entirely through a thickness of the glass core 310.

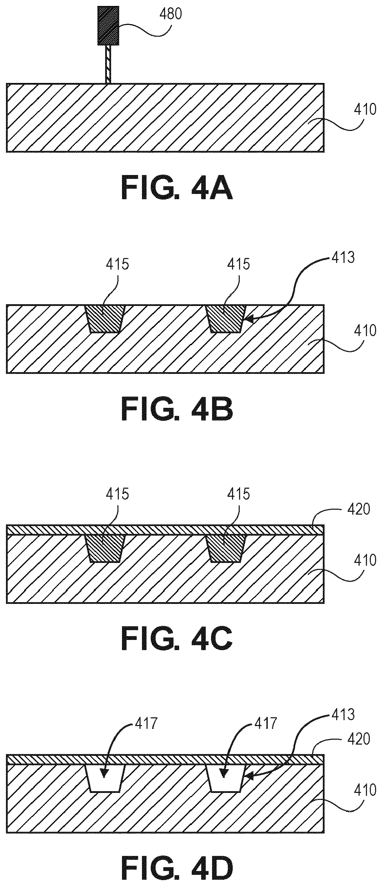

Referring now to Figures 4A-4D, a series of cross-sectional illustrations depicting a process for forming a sensor device is shown, in accordance with an embodiment. In an embodiment, the sensor device may include a plate that is suspended over a cavity. Particularly, the sensor device is fabricated in the core (e.g., a glass core) of an electronic package. By integrating the sensor device directly into the core of the package substrate, the assembly complexity is reduced. Additionally, the form factor of the device can be shrunk compared to a device where discrete sensors are added to the electronic system.

Typically, existing sensor architectures are manufactured using silicon-based MEMS approaches, and then packaged and assembled onto the package or board as a discrete part. Such sensors packages are generally tall (e.g., approximately 1mm or greater in height) which can be challenging to accommodate in certain platforms where a thin form factor is desired. Moreover, the sensor devices are manufactured at wafer-level using expensive materials (e.g., silicon) and require assembly and packaging, which adds to the overall system cost.

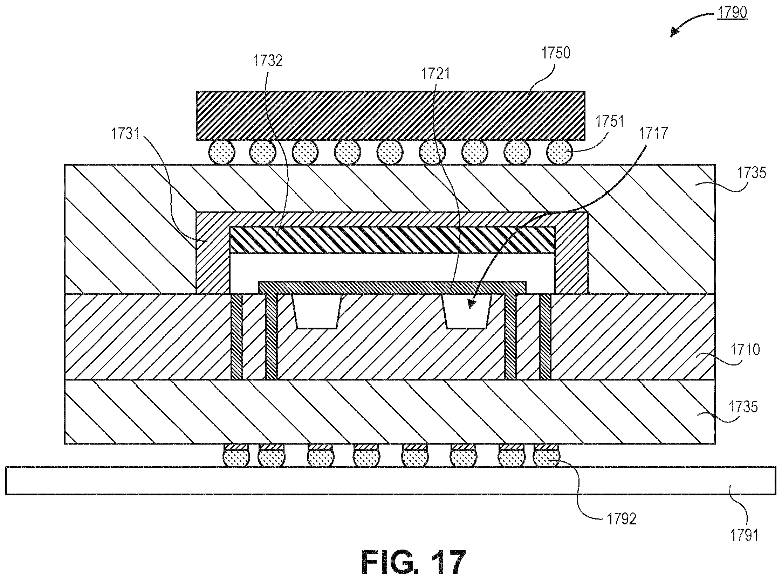

In embodiments disclosed herein, a sensor platform using suspended structures that can be built as part of the package substrate is described. In an embodiment, laser assisted etching of a glass core is used to enable the suspended structures. After the suspended structures are formed, piezoelectric material can be added to the suspended structures in order to aid in the conversion of a mechanical signal into an electrical signal. Such sensor architectures enable very low cost and small form factor (e.g., low Z-height) sensors. The sensors can be made very compact, and enable the placement of multiple sensors across the glass core to provide spatial and multi-modal sensing of the substrate. Sensors described herein can be for many different applications. For example, sensors may be used to enhance thermal management/control systems, used for IoT applications, used for handling sensing/tracking of products during shipping, and/or used for calibrating other kinds of sensors that are temperature sensitive, such as accelerometers and gyroscopes. The sensors described herein may be passive sensors. That is, the sensors may require driving circuitry in order to properly function. It is to be understood that the sensors described herein may be driven by either a dedicated IC (e.g., an ASIC) or a circuitry within a larger SoC that is part of the package module as shown in Figure 17.

The principle of operation of this sensing platform may utilize piezoelectric materials to convert externally applied quantities (e.g., pressure, acceleration, temperature, etc.) into electrical signals whose magnitude is used by the processor to quantify the applied quantity. In some embodiments, a magnetic based actuation may be used in addition to or in the place of piezoelectric actuation. In Figures 4A-4D, generic sensors are shown. However, it is to be appreciated that those skilled in the art may make suitable modifications in order to adapt the sensors for more specialized use in quantifying certain applied quantities.

Referring now to Figure 4A, a cross-sectional illustration of a glass core 410 is shown, in accordance with an embodiment. In an embodiment, the glass core 410 may have a thickness between approximately 50µm and approximately 1,000µm. The glass core 410 may be a glass material that can be patterned with a laser assisted etching process similar to any of the embodiments described in greater detail above. In an embodiment, the glass core 410 is exposed to radiation from a laser 480. In a particular embodiment, the laser 480 exposes only a single surface of the glass core 410.

Referring now to Figure 4B, a cross-sectional illustration of the glass core 410 after exposed regions 415 are formed is shown, in accordance with an embodiment. In an embodiment, the exposed region 415 may be formed into the top surface of the glass core 410 by the laser 480. The exposed regions 415 may extend partially through a thickness of the glass core 410. The exposed regions 415 may also comprise tapered sidewalls 413 in some embodiments. However, it is to be appreciated the sidewall 413 taper may be substantially zero. That is, the exposed regions 415 may have substantially vertical sidewalls 413 in some embodiments.

Referring now to Figure 4C, a cross-sectional illustration of the glass core 410 after a layer 420 is disposed over the glass core 410 is shown, in accordance with an embodiment. In an embodiment, the layer 420 may be any layer suitable for forming an actuator over a cavity. In a particular embodiment, the layer 420 may comprise a conductive material, such as, but not limited to, copper. In an embodiment, the layer 420 may be deposited with a cold spray process, a chemical vapor deposition (CVD) process, a physical vapor deposition (PVD) process, or the like. In an embodiment, the layer 420 is disposed over the top surface of the glass core 410 and directly over the exposed regions 415.

In an embodiment, the layer 420 may be a patterned layer in some embodiments. For example, openings (not shown) may be made through the layer 420. In some embodiments, one or more openings may be made over the exposed regions 415 out of the plane of Figure 4C. The openings may reveal portions of the exposed regions 415 so that an etchant can remove the exposed regions 415. Additionally, while the layer 420 is continuous over the left exposed region 415 and the right exposed region 415, it is to be appreciated that each exposed region 415 may be covered by discrete layers 420 that do not contact each other.

Referring now to Figure 4D, a cross-sectional illustration of the glass core 410 after the exposed regions 415 are removed to form openings 417 is shown, in accordance with an embodiment. In an embodiment, the regions 415 may be removed with an etchant that passes through openings (not shown in Figure 4D) in the layer 420. For example, the etchant may be a wet etchant. In an embodiment, the openings 417 are blind openings 417. That is, the openings 417 do not pass entirely through a thickness of the glass core 410. In some embodiments, the openings 417 have sidewalls 413 that are tapered.

In an embodiment, the portions of the layer 420 that span the openings 417 may be used as a sensing actuator. For example, deflection of the layer 420 into and out of the opening 417 may be converted to an electrical signal through piezoelectric and/or electromagnetic actuation, as will be described in greater detail below.

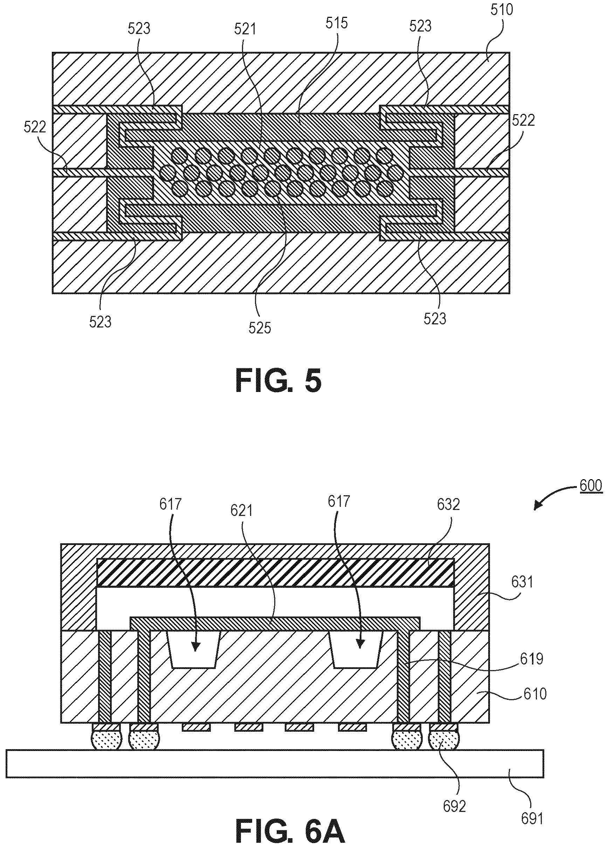

Referring now to Figure 5, a plan view illustration of a sensor structure on a glass core 510 is shown, in accordance with an embodiment. In an embodiment, the glass core 510 may be similar to any of the glass cores described in greater detail above. In an embodiment, the glass core 510 has been exposed with a laser to make an exposed region 515. A proof mass 521 may be provided above the exposed region 515. The proof mass 521 may be coupled to anchors 522 and/or spring loads 523. For example, each corner of the proof mass 521 may be coupled to the glass core 510 by spring loads 523, and ends of the proof mass 521 may be coupled to the glass core 510 by the anchors 522. In subsequent processing operations, the proof mass 521 may be released by removing the exposed region 515. For example, an etching process may remove the exposed regions 515. In some embodiments, holes 525 through the proof mass 521 may provide additional pathways for an etchant to reach the exposed region 515 in order to aid in the release of the proof mass 521.

In one embodiment, the sensor in Figure 5 operates as an accelerometer, though it is to be appreciated that similar principles apply to other sensor architectures. During operation, the proof mass 521 deflects (e.g., up and down in Figure 5) when an external acceleration is applied. The deformation induces stresses in a piezoelectric film (not shown) that is mechanically coupled to the base structure. This generates a voltage across the film which is proportional to the applied acceleration. The voltage is transmitted to a processor (or a local sensor hub with processing functionality), and the amplitude of the signal is used to determine the applied acceleration. For example, a lookup table may be used in some embodiments. Alternatively, if magnetically actuated, then the applied acceleration shifts the resonance frequency of the anchor 522. This resonance frequency can be detected by the processor, and the relative shift of the frequency is used to determine the applied acceleration (e.g., with a lookup table).

Referring now to Figures 6A-6C, cross-sectional illustrations of electronic packages 600 that include magnetically actuated sensors are shown, in accordance with additional embodiments. In the embodiments disclosed, the glass core 610 is assembled with various layers and coupled to a board 691. It is to be appreciated that similar architectures may be used in sensors that include alternative sensing mechanisms (e.g., piezoelectric based sensors).

Referring now to Figure 6A, a cross-sectional illustration of an electronic package 600 is shown, in accordance with an embodiment. In an embodiment, the electronic package comprises a glass core 610. In an embodiment, the glass core 610 may be substantially similar to any of the glass cores described in greater detail above. In an embodiment, the glass core 610 may be coupled to a board 691 by interconnects 692. While shown as solder balls, it is to be appreciated that interconnects 692 may include any suitable interconnect architecture, such as sockets or the like. In an embodiment, a proof mass 621 may be coupled to vias 619 through the glass core 610. In an embodiment, the proof mass 621 may extend across blind openings 617. As such, the proof mass 621 is free to oscillate. Particularly, the proof mass 621 may oscillate into and out of the plane of Figure 6A (e.g., in the X-Y plane). There may also be some displacement in the Z-direction as well. A lid 631 may be provided over the proof masses 621 and openings 617. The lid 631 may provide a hermetic seal around the sensor architecture. A magnetic block 632 may be integrated into the lid 631 in some embodiments. Additional buildup layers (not shown) may be fabricated above and/or below the glass core 610. Additionally, it is to be appreciated that multiple proof masses 621 may be oriented ninety degrees (or sixty degrees or forty five degrees) with respect to each other in order to measure the quantity of interest (e.g., acceleration) along two or more axes.

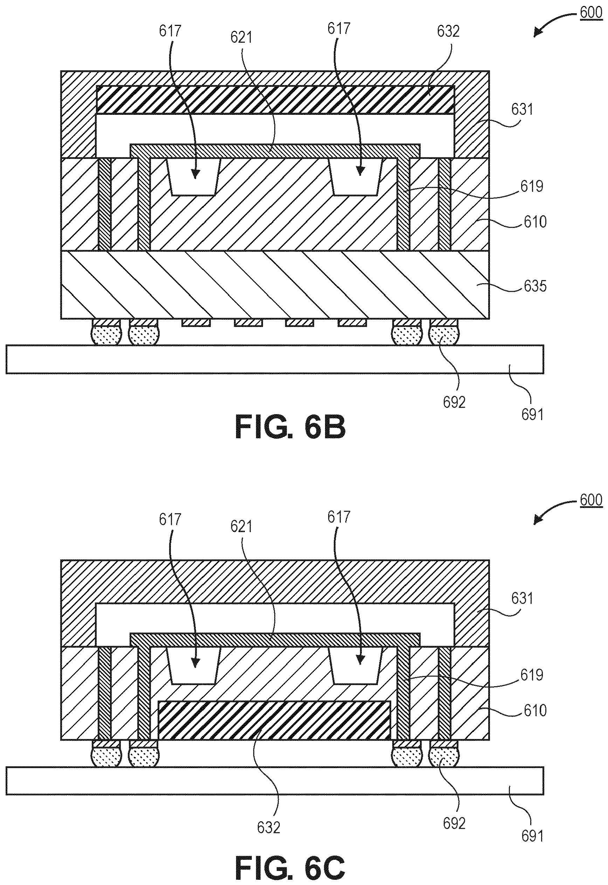

Referring now to Figure 6B, a cross-sectional illustration of an electronic package 600 is shown, in accordance with an additional embodiment. As shown, the electronic package 600 in Figure 6B may be substantially similar to the electronic package 600 in Figure 6A, with the addition of buildup layers 635 below the glass core 610. In an embodiment, the buildup layers 635 may include one or more dielectric layers with conductive routing (not shown). For example, the conductive routing may include pads, traces, vias, and the like. The conductive routing may couple the vias 619 through the glass core 610 to the interconnects 692 in some embodiments.

Referring now to Figure 6C, a cross-sectional illustration of an electronic package 600 is shown, in accordance with an additional embodiment. In an embodiment, the lid 631 does not include a magnetic block. Instead, the magnetic block 632 is provided in the glass core 610 below the blind openings 617. For example, a blind cavity can be formed into the bottom surface of the glass core 610, and the magnetic block 632 can be placed in the cavity. Such an embodiment may simplify the manufacture and assembly of the lid 631.

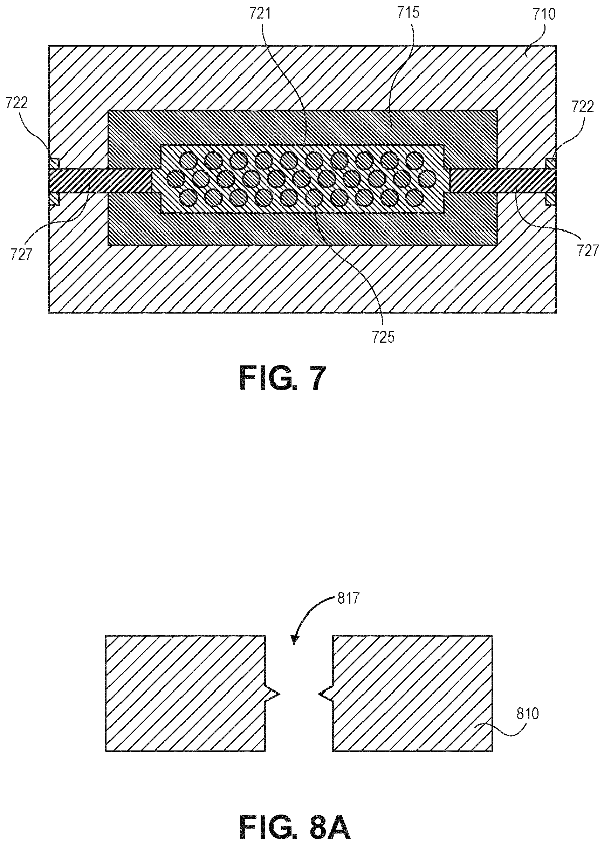

Referring now to Figure 7, a plan view illustration of a glass core 710 is shown, in accordance with yet another embodiment. As shown, the glass core 710 may comprise an exposed region 715 that was morphologically changed by exposure to a laser. In an embodiment, a proof mass 721 is provided over the exposed region 715. In an embodiment, holes 725 may be provided through the proof mass 721. The proof mass 721 may be coupled to the glass core 710 by anchors 722. Portions of the anchors 722 are covered with a piezoelectric layer 727. After the exposed region 715 is removed, the proof mass 721 is free to displace and induce a strain on the anchors 722. The strain is induced into the piezoelectric layers 727 to convert a mechanical displacement into an electrical signal.

As noted above, high aspect ratio vias are useful for providing various structures within a glass core. The use of laser assisted etching processes allow for the creation of via openings with aspect ratios that are approximately 5:1 or greater, approximately 10: 1 or greater, or approximately 50:1 or greater. However, after forming the via openings, a plating process is still needed to fill the high aspect ratio openings. As shown in Figures 8A-8D, a process is depicted for filing high aspect ratio via openings. However the process shown in Figures 8A-8D results in the formation of a seam and voids.

Referring now to Figure 8A, a cross-sectional illustration of a glass core 810 is shown, in accordance with an embodiment. In an embodiment, the glass core 810 may comprise a via opening 817. In the illustrated embodiment, the via opening 817 has an hourglass shape. Though it is to be appreciated that other shapes may be provided depending on the laser exposure and etching processes used. For example, via openings 817 may be similar to any of the via openings described in greater detail above. In an embodiment, the via opening 817 may be a high aspect ratio feature. That is the via opening 817 may have an aspect ratio of approximately 5:1 or greater, approximately 10:1 or greater, or approximately 50:1 or greater.

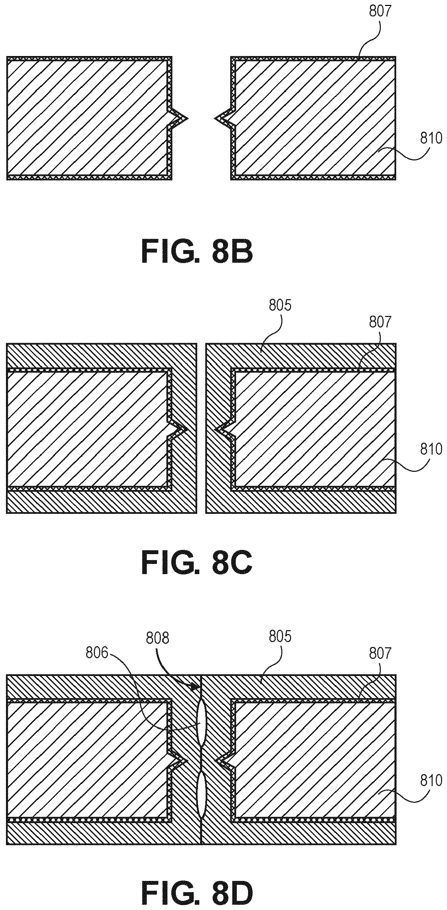

Referring now to Figure 8B, a cross-sectional illustration of the glass core 810 after a seed layer 807 is disposed over the exposed surface of the glass core 810 is shown, in accordance with an embodiment. In an embodiment, the seed layer 807 may be deposited with a conformal deposition process, such as an ALD process. In an embodiment, the seed layer 807 may comprise copper, ruthenium, cobalt or another conductive material. The seed layer 807 may have a thickness range that is approximately 5-50 nm depending on metal seed used. For example a ruthenium seed may have a thickness with a 5nm-20nm range, while a copper seed may range from between 20nm-50 nm. While the seed layer 807 is shown as being directly on the glass, it is to be appreciated that a thin adhesion layer (e.g., 1nm-5 nm) may be present between the glass core 810 and metal seed layer 807 to mitigate any seed delamination. Typical adhesion layers can include but are not limited to TiOx, TiNx, and TaNx. In addition to providing sufficient adhesion between metal seed layer 807 and the glass core 810, the adhesion layer can behave as a barrier for metal migration.

Referring now to Figure 8C, a cross-sectional illustration of the glass core 810 after a plating process is used to form conductive layer 805 is shown, in accordance with an embodiment. In an embodiment, the plating process may be an electrolytic plating process. While shown as having different shadings, in some embodiments, the seed layer 807 and the conductive layer 805 may comprise the same material (e.g., copper). As shown, the conductive layer 805 fills the via opening 817 laterally. That is, the conductive layer 805 starts plating at the sidewalls of the via opening 817 and plates laterally inward.

Referring now to Figure 8D, a cross-sectional illustration of the glass core 810 after the plating process is completed is shown, in accordance with an embodiment. As shown, the lateral plating within the opening 817 results in the formation of one or more undesirable features. One such feature is the presence of a seam 808 down the middle of the via opening 817. The seam 805 may be caused by the growth fronts of the conductive layer 805 meeting at the center of the via opening 817. Additionally, the lateral plating process may result in the formation of one or more voids 806 in the conductive structure 805. Voids 806 provide reliability risks and increases the resistance through the conductive structure 805 from one side of the glass core 810 to the other side of the glass core 810.

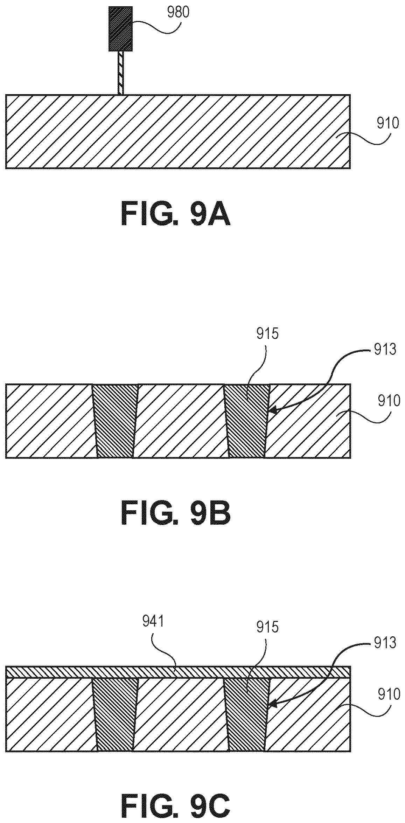

Accordingly, embodiments disclosed herein include metal deposition processes that result in vias that are free from seams and voids. Particularly, a bottom-up plating process can be used in some embodiments. Such a process is made possible due to the laser assisted etching process. For example, a laser exposed region may be provided through a thickness of the glass core, and a metal layer is plated over one end of the exposed region. The exposed region can then be removed, and a via opening with a bottom surface of copper is provided. The via opening is then plated up from the bottom copper surface. Figures 9A-9E provide a cross-sectional illustration of a process for forming via structures with a bottom-up plating process. While shown without an ALD deposition process, it is to be appreciated that seed layers and/or adhesion layers may be disposed over exposed surface of the via opening with an ALD process in some embodiments.

Referring now to Figure 9A, a cross-sectional illustration of a glass core 910 is shown, in accordance with an embodiment. In an embodiment, the glass core 910 may be substantially similar to any of the glass cores described in greater detail above. For example, the glass core 910 may comprise a thickness between approximately 50µm and approximately 1,000µm. The glass core 910 may comprise a glass material that is suitable for laser assisted etching processes. For example, a laser 980 may be scanned across a surface of the glass core 910 to provide one or more exposed regions. In the embodiment shown in Figure 9A, the laser 980 is only exposed on a top surface of the glass core 910. However, in other embodiments, the laser 980 may pass over both the top surface and the bottom surface of the glass core 910.

Referring now to Figure 9B, a cross-sectional illustration of the glass core 910 after the exposed regions 915 are formed is shown, in accordance with an embodiment. In an embodiment, the exposed regions 915 are regions of the glass core 910 that have undergone a morphological change compared to the rest of the glass core 910. For example, the exposed regions 915 may have been transformed from an amorphous structure to a crystalline structure. In the illustrated embodiment, the exposed regions 915 include sidewalls 913 that are tapered. A single taper is shown in Figure 9B, but it is to be appreciated that other tapers (e.g., hourglass shaped profiles) may be provided depending on the processes used to form the exposed regions 915. For example, an hourglass shaped profile may be provided when the laser 980 exposes both the top surface and the bottom surface of the glass core 910.

Referring now to Figure 9C, a cross-sectional illustration of the glass core 910 after a conductive layer 941 is disposed over a surface of the glass core 910 is shown, in accordance with an embodiment. In an embodiment, the conductive layer 941 may be deposited with any suitable process, such as, but not limited to, cold spraying, CVD, PVD, or the like. In an embodiment, the thickness of the conductive layer 941 may be approximately 15µm or less. In a particular embodiment, the conductive layer 941 comprises copper, though it is to be appreciated that other conductive materials may also be used in different embodiments. While referred to herein as a conductive layer 941, it is to be appreciated that the conductive layer 941 may sometimes be referred to as an underlying pad.

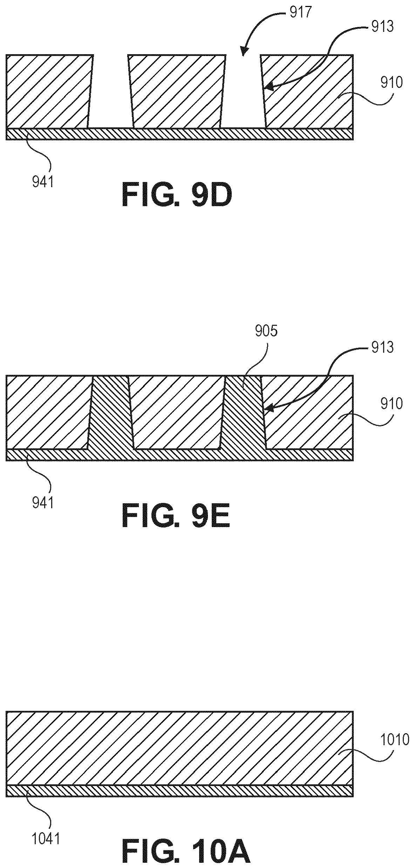

Referring now to Figure 9D, a cross-sectional illustration of the glass core 910 after the exposed regions 915 are removed is shown, in accordance with an embodiment. In an embodiment, the exposed regions 915 may be removed with an etching process that is selective to the exposed regions 915 over the unexposed regions of the glass core 910. The removal of the exposed regions 915 results in the formation of openings 917 through a thickness of the glass core 910. The openings 917 expose the underlying conductive layer 941.

Referring now to Figure 9E, a cross-sectional illustration of the glass core 910 after vias 905 are formed in the openings 917 is shown, in accordance with an embodiment. In an embodiment, the openings 917 are filled with a bottom-up plating process. Using a bottom-up process is an improvement over the sidewall plating described above. Particularly, the bottom-up process does not need to worry about pinching off and forming voids or dealing with a seam down the middle of the via 905. As such, the electrical performance and reliability of the vias 905 are improved compared to the vias formed with the process shown in Figures 8A-8D.

Referring now to Figures 10A-10G, a series of cross-sectional illustrations depicting a process for forming an alternative structure to fill the openings is shown, in accordance with an embodiment. Particularly, the embodiment shows a process that includes forming the conductive layer before forming the exposed regions of the glass core 1010. However, the resulting structure of the via openings 1017 is similar to the via openings 917 shown in Figure 9D.

Referring now to Figure 10A, a cross-sectional illustration of a glass core 1010 is shown, in accordance with an embodiment. In an embodiment, the glass core 1010 may be substantially similar to any of the glass cores described in greater detail above. For example, the glass core 1010 may undergo a morphological change when exposed to a laser. In an embodiment, a conductive layer 1041 may be disposed over a surface of the glass core 1010. The conductive layer 1041 may be deposited with any suitable process, such as cold spraying, CVD, PVD, or the like. In an embodiment, the conductive layer 1041 comprises copper or any other suitable conductive material.

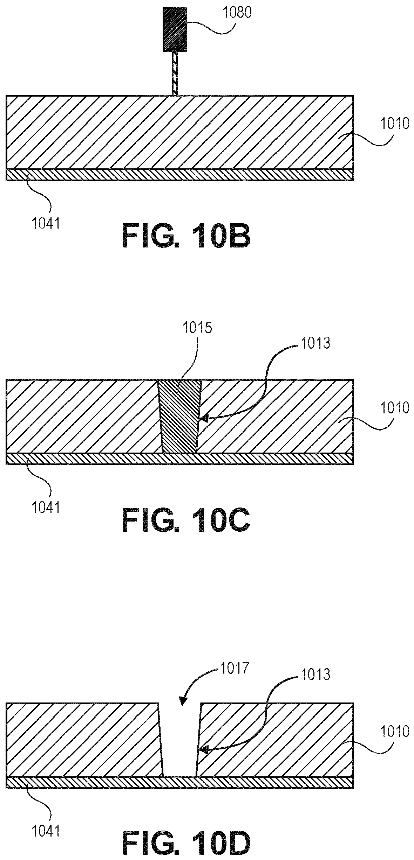

Referring now to Figure 10B, a cross-sectional illustration of the glass core 1010 being exposed to a laser 1080 is shown, in accordance with an embodiment. In an embodiment, the laser 1080 exposure is provided on the surface of the glass core 1010 opposite from the conductive layer 1041.

Referring now to Figure 10C, a cross-sectional illustration of the glass core 1010 after exposure to a laser 1080 is shown, in accordance with an embodiment. As shown, the laser 1080 exposure results in the formation of an exposed region 1015. The exposed region 1015 may have undergone a morphological change so that the exposed region 1015 is etch selective to the remainder of the glass core 1010. For example, the exposed region 1015 may have a crystalline microstructure and the remainder of the glass core 1010 may have an amorphous microstructure. In an embodiment, the exposed region 1015 may have tapered sidewalls 1013. In other embodiments, the taper 1013 may be omitted, and substantially vertical sidewalls may be present.

Referring now to Figure 10D, a cross-sectional illustration of the glass core 1010 after the exposed region 1015 is removed is shown, in accordance with an embodiment. Removal of the exposed region 1015 results in the formation of a via opening 1017. As shown, the conductive layer 1041 spans across the backside surface of the via opening 1017. As such, a bottom-up plating process is possible.

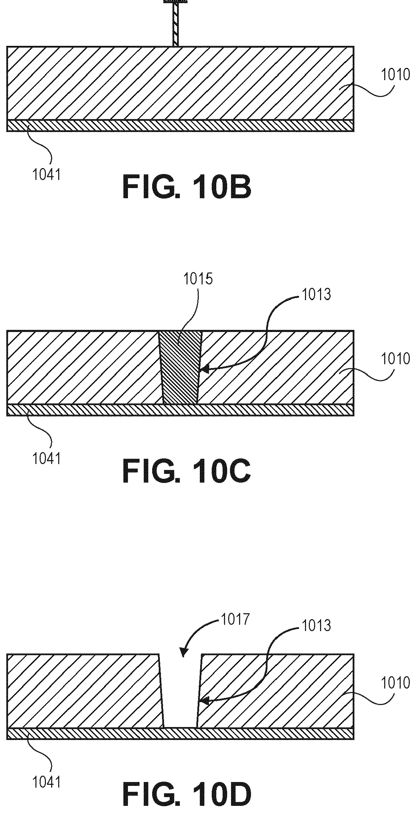

Referring now to Figure 10E, a cross-sectional illustration of the glass core 1010 after a first via layer 1005 is plated from the conductive layer 1041 is shown, in accordance with an embodiment. In an embodiment, the first via layer 1005 is plated with a bottom-up process. As such, the height of the first via layer 1005 can be controlled to a height that is less than the total height of the via opening 1017.

Referring now to Figure 10F, a cross-sectional illustration of the glass core 1010 after a dielectric layer 1044 is disposed over the first via layer 1005 is shown, in accordance with an embodiment. In an embodiment, the dielectric layer 1044 may be a dielectric material that electrically isolates the first via layer 1005 from a subsequently formed second via layer 1046. For example, the first via layer 1005 and the second via layer 1046 may be held at different potentials. In some embodiments, the first via layer 1005, the dielectric layer 1044, and the second via layer 1046 form a capacitor structure.

Referring now to Figure 10G, a cross-sectional illustration of the glass core 1010 after the second via layer 1046 is formed is shown, in accordance with an embodiment. Since the first via layer 1005 and the dielectric 1044 partially fill the opening 1017, the aspect ratio of the remainder of the opening 1017 is reduced. As such, a bottom-up plating process may not be necessary for the second via layer 1046.

In addition to the formation of suspended sensor architectures and fully filled high aspect ratio vias, embodiments disclosed herein include the use of laser assisted glass core patterning processes in order to fabricate mm-wave and/or sub-THz antennas or launchers. As described above, the incorporation of such structures into the glass core eases complexity and can improve form factors.

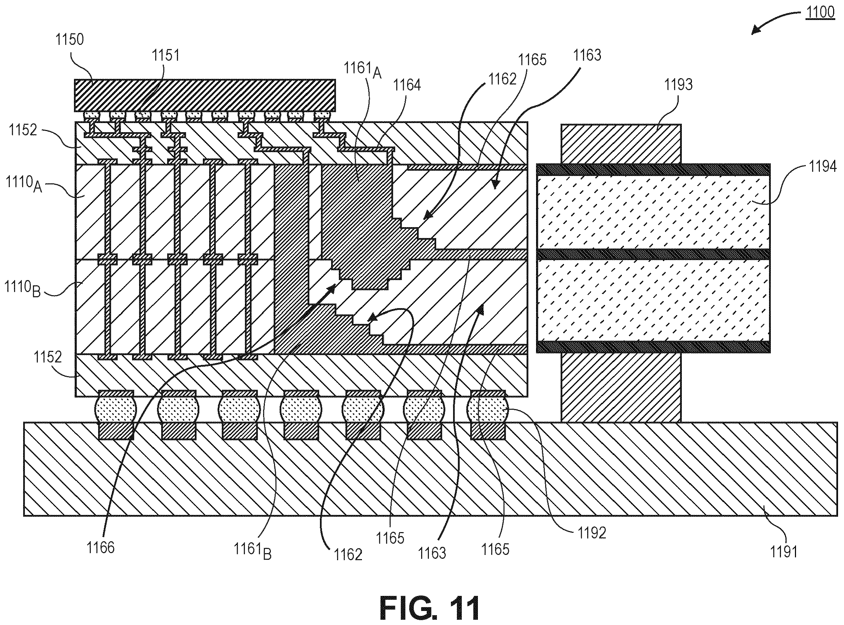

Referring now to Figure 11, a cross-sectional illustration of an electronic system 1100 is shown, in accordance with an embodiment. In Figure 11, a package substrate is coupled to a board 1191, such as a printed circuit board (PCB), by interconnects 1192. The package substrate may comprise a glass core 1110 and buildup layers 1152 above and/or below the glass core 1110. In the illustrated embodiment, a pair of glass cores 1110_{A} and 1110_{B} are bonded together (e.g., with a hybrid bonding architecture or a direct bonding architecture) in order to form the core of the package substrate. However, it is to be appreciated that a single glass core 1110 may be used in some embodiments, or three or more glass cores 1110 may be used in other embodiments.

In the illustrated embodiment, a die 1150 is attached to the top buildup layers 1152. The die 1150 may be a transceiver device suitable for sending and/or receiving mm-wave and/or sub-THz signals. The die 1150 may be communicatively coupled to another die (e.g., a processor or the like) that is not shown in Figure 11. The transceiver die 1150 may include a clock generator (e.g., a local oscillator) and lock subsystem. The die 1150 may also comprise an up/down conversion subsystem, a baseband subsystem, a DSP and equalization subsystem, a dispersion compensation subsystem, low-noise and power amplifiers, an analog-front-end (AFE) subsystem, and the like.

In an embodiment, the die 1150 is coupled to launchers 1161 through conductive routing 1164 (e.g., traces, vias, pads, etc.) in the buildup layer 1152. A launcher 1161 is a structural device that is used to propagate the mm-wave and/or sub-THz signal through a given medium (e.g., the glass of the glass core 1110) or receive mm-wave and/or sub-THz signals from the medium. In some instances the launchers 1161 may be referred to as antennas. In the illustrated embodiment, the launchers are conductive fins that are structured as Vivaldi type launchers. That is, the fins 1161_{A} and 1161_{B} comprise tapered slot structures with tapered edges 1162 and 1166. Though, it is to be appreciated that other launcher architectures may be used, such as dipole antennas, for example. In an embodiment, the fins 1161 may be formed with laser assisted glass etching processes, such as those described in greater detail above.

In an embodiment, the tapered edges 1162 and 1166 may end at conductive lines 1165 that isolate the signals in waveguides 1163 that extend to an edge of the cores 1110_{A} and 1110_{B}. The waveguides 1163 may be coupled to dielectric waveguides 1194 that are external to the package substrate. In an embodiment, the dielectric waveguides 1194 may be held in place by a connector 1193 that is secured to the board 1191.

In the illustrated embodiments, the pair of launchers 1161_{A} and 1161_{B} are stacked vertically. That is, the first launcher 1161_{A} launches mm-waves and/or sub-THz waves into the first glass layer 1110_{A}, and the second launcher 1161_{B} launches mm-waves and/or sub-THz waves into the second glass layer 1110_{B}. While two layers are shown, it is to be appreciated that additional layers may be used, as will be described in greater detail below. Additionally, it is to be appreciated that an array of launchers 1161 may be provided in a single glass layer 1110.

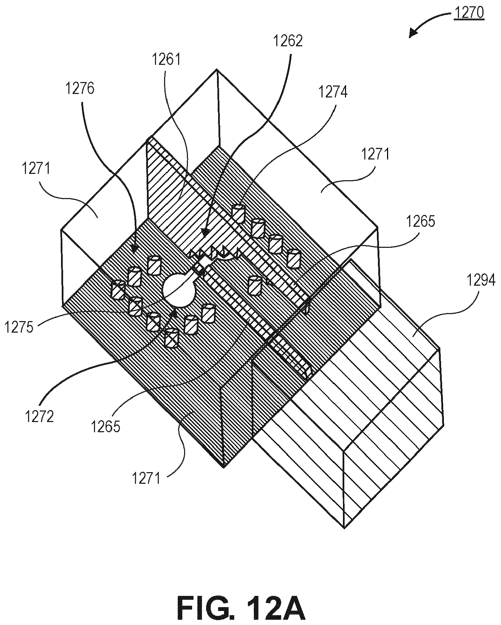

Referring now to Figure 12A, a perspective view illustration of a launcher system 1270 is shown, in accordance with an embodiment. In Figure 12A, the material of the glass layer 1110 in Figure 11 is omitted, and the conductive sidewalls 1271 are illustrated as transparent in order to more clearly depict embodiments described herein. The conductive sidewalls may be formed with a laser assisted glass etching process, such as the processes described in greater detail above.

As shown, the launcher system 1270 may include a base layer 1276. The base layer 1276 is a conductive material, such as copper. A slot line 1272 passes through a thickness of the base layer 1276. In an embodiment, the slot line 1272 has a dumbbell shape. That is, a first end and a second end of the slot line 1272 have widths that are greater than at a center of the slot 1272. The center of the slot line 1272 may be the location where the feed line 1275 is exposed. The feed line 1275 may be a microstrip, a stripline, an embedded microstrip, or the like. In an embodiment, the transition at the end of the feed line 1275 is a direct via-feed into the slot line 1272. However, other networks may use an open stub, an open radial stub, or the like. The signal travels from the feed line 1275 into the vertical slot along the Z-axis as the circular terminations (i.e., the ends of the dumbbell) on the X-Y plane create an open for the signal and prevents propagation in the X-Y plane. Posts 1274 also help shield the signal. As the signal travels along the launcher 1261 it reaches the stepped portion 1262 and builds up gradually until the signal reaches the lines 1265 and ultimately the interface with the waveguide 1294 where the signal will continue propagating.

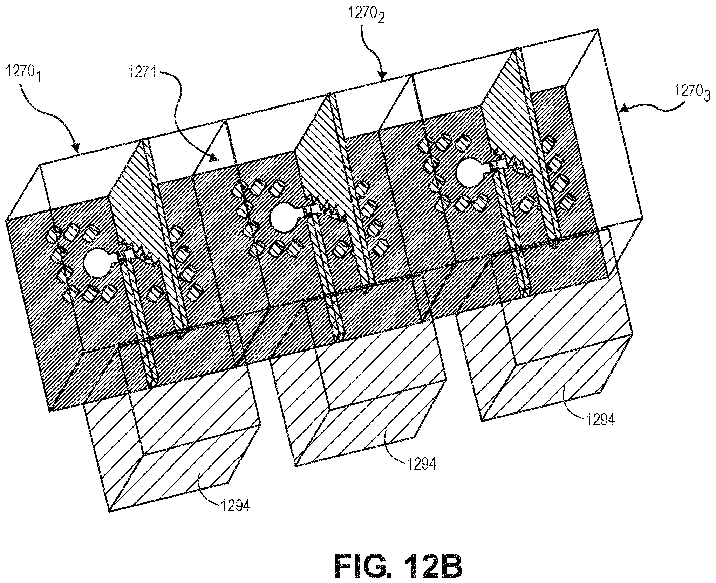

Referring now to Figure 12B, a perspective view illustration of a plurality of launcher systems 1270₁ - 1270₃ are shown, in accordance with an embodiment. The launcher systems 1270 may be substantially similar to the launcher system 1270 described with respect to Figure 12A. As shown, the launcher systems 1270 may be laterally adjacent to each other. In some embodiments, the launcher systems 1270 may share walls 1271 and be formed within the same glass layer of a package substrate. While three launcher systems 1270 are shown, it is to be appreciated that any number of launcher systems may be provided within a single glass layer of the package substrate.

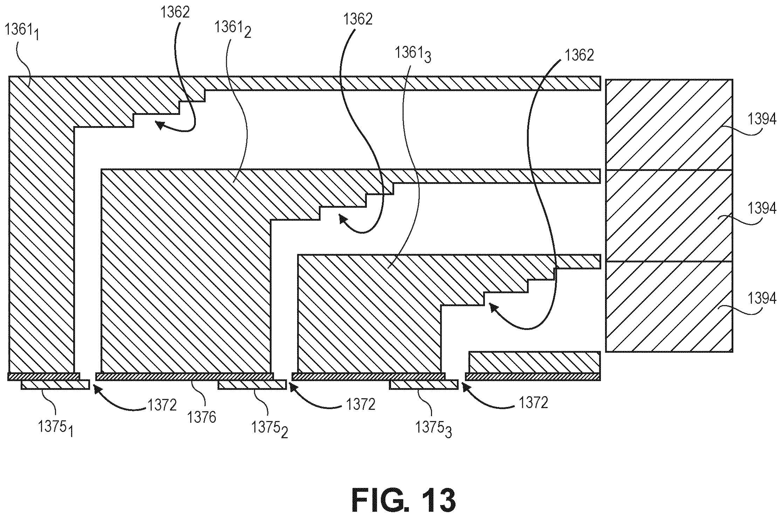

Referring now to Figure 13, a cross-sectional illustration of glass layers in a package substrate are shown, in accordance with an embodiment. As shown, vertically stacked launchers 1361₁ - 1361₃ are shown, in accordance with an embodiment. The signal path of each of the launchers 1361 may propagate in different glass layers (not shown). For example, launcher 1361₁ is in a top glass layer, launcher 1361₂ is in a middle glass layer, and launcher 1361₃ is in a bottom glass layer. Each launcher 1361 may include a stepped surface 1362. In an embodiment, each launcher 1361 is fed from a feed line 1375₁ - 1375₃ that propagate signals through slot lines 1372. The signal travels along the launcher 1361 and ultimately turns horizontal so that the signals couple with dielectric waveguides 1394 adjacent to the glass layers.

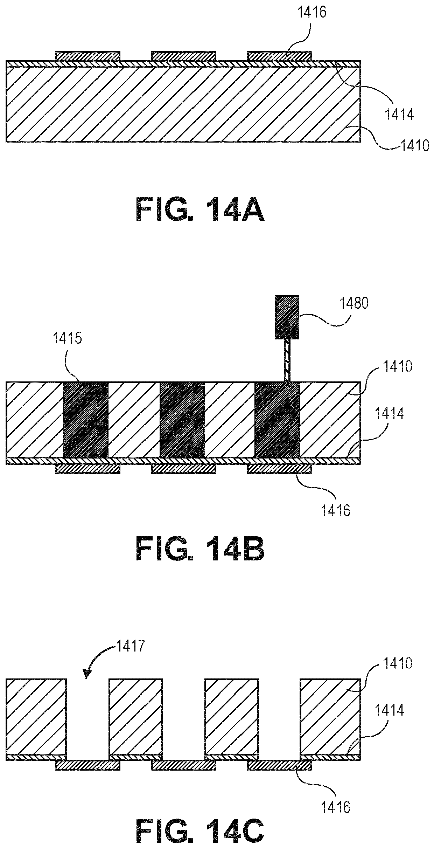

Referring now to Figures 14A-14F, a series of cross-sectional illustrations depicting a process for fabricating structures using laser-assisted etching processes is shown, in accordance with an embodiment.

Referring now to Figure 14A, a cross-sectional illustration of a core 1410 is shown, in accordance with an embodiment. In an embodiment, the core 1410 is a glass core. In an embodiment, conductive pads 1416 may be provided over the core 1410. An adhesive layer 1414 (e.g., TiNₓ, TiOₓ, SiNₓ, W, organic polymer, or the like) may be provided between the conductive pads 1416 and the core 1410 in some embodiments. Although, not shown here a thin metal seed (Ti, Ta) may be present directly under conductive pads 1416 but above adhesive layer 1414.

Referring now to Figure 14B, a cross-sectional illustration of the core after a laser 1480 exposure process is shown, in accordance with an embodiment. As shown, a plurality of exposed regions 1415 may be provided over the pads 1416. The exposed regions may be regions of the core 1410 that undergo a morphological change.

Referring now to Figure 14C, a cross-sectional illustration of the core 1410 after openings 1417 are formed through the core 1410 is shown, in accordance with an embodiment. In an embodiment, the openings 1417 may be formed with an etching process that is selective to the exposed regions 1415. In the illustrated embodiment the openings 1417 have substantially vertical sidewalls. However, in other embodiments, the openings 1417 may have tapered sidewalls.

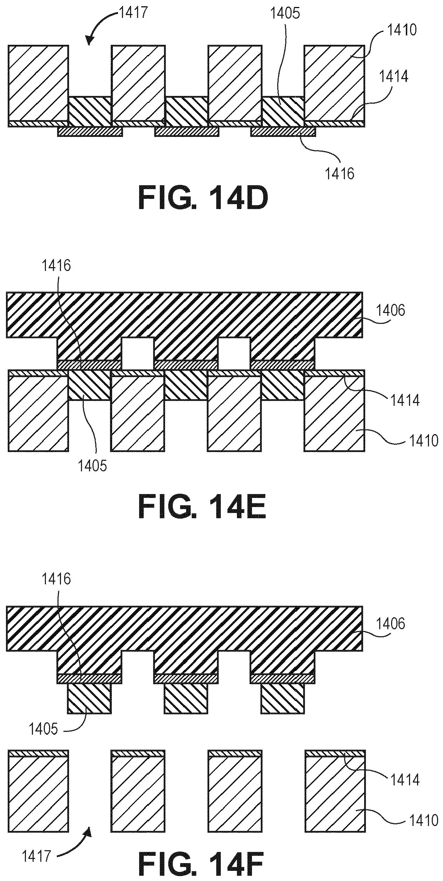

Referring now to Figure 14D, a cross-sectional illustration of the core 1410 after first portions 1405 are plated up from the pads 1416. The plating process may be an electrolytic or electroless plating process. In an embodiment, the first portions 1405 comprise the same material as the pads 1416. As shown, the first portions 1405 may not entirely fill the openings 1417.

Referring now to Figure 14E, a cross-sectional illustration of the core 1410 after a carrier 1406 is provided over the pads 1416. In an embodiment, the carrier 1406 may include a post for each of the pads 1416. The carrier 1406 may be mechanically coupled to the pads 1416 with a vacuum force, an electrostatic force, van der walls forces, or any other attachment mechanism.

Referring now to Figure 14F, a cross-sectional illustration of the core 1410 after the pads 1416 and the first portions 1405 are removed from the core 1410 is shown, in accordance with an embodiment. In an embodiment, the pads 1416 and the first portions 1405 may be removed with a mechanical force that breaks an attachment to the core 1410. In an embodiment, the resulting structures (i.e., pads 1416 and first portions 1405) may be used as discrete components that are to be integrated into an electronic package, or for any other suitable purpose.

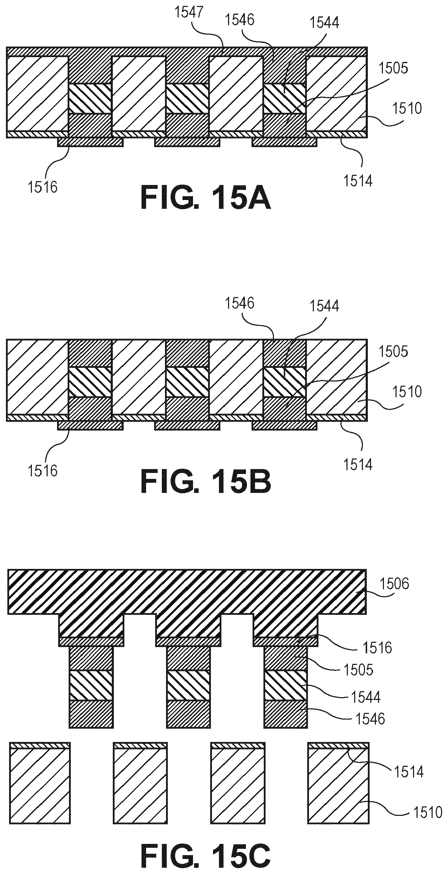

Referring now to Figures 15A-15C a series of cross-sectional illustrations depicting a process for forming capacitors in the core 1510 is shown, in accordance with an embodiment.

Referring now to Figure 15A, a cross-sectional illustration of a core 1510 is shown, in accordance with an embodiment. In an embodiment, the core 1510 may be a glass core. The glass core 1510 may be patterned with laser-assisted etching processes. Capacitors may be disposed in the openings. For example, first portions 1505 may be plated up from pads 1516. Pads 1516 may be disposed over an adhesive layer 1514. A dielectric layer 1544 is disposed over the first portions 1505, and a second portion 1546 is disposed over the dielectric layer 1544. In an embodiment, overburden 1547 may be plated over a top surface of the core 1510.

Referring now to Figure 15B, a cross-sectional illustration of the core 1510 after the overburden 1547 is removed. For example, the overburden 1547 may be removed with a polishing process, such as a CMP process.

Referring now to Figure 15C, a cross-sectional illustration of the core 1510 after the capacitors are removed from the core 1510 is shown, in accordance with an embodiment. In an embodiment, the capacitors may be removed with a carrier 1506. The carrier 1506 may be substantially similar to the carrier 1506 described above with respect to Figure 14E. For example, each pad 1516 may be contacted by the carrier 1406. The carrier 1506 is lifted away from the core 1510 to mechanically separate the capacitors from the core 1510. The capacitors may be used as discrete components in other electronic packaging applications. However, it is to be appreciated that the core 1510 may be part of an electronic package, and the capacitors may remain in the core 1510 as integrated devices.

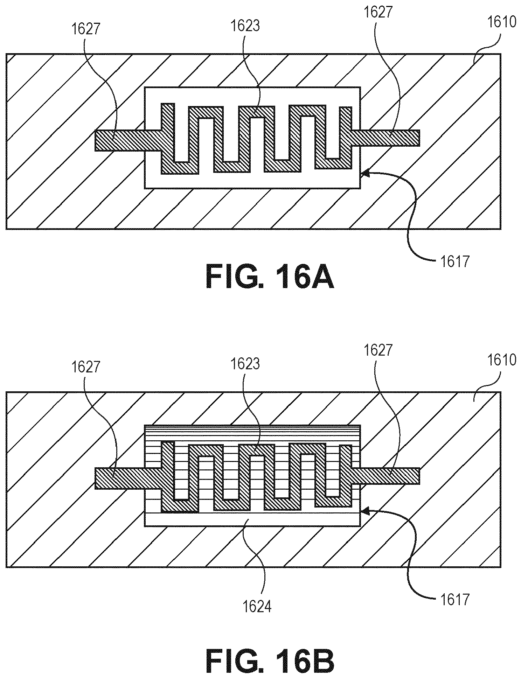

Referring now to Figure 16A and 16B, plan view illustrations of device are shown, in accordance with embodiments described herein. Instead of having a proof mass type structure, a serpentine trace 1623 may be provided across the cavity 1617 in the core 1610. The serpentine trace 1623 may be anchored to the core 1610 by anchors 1627. The serpentine structure may be formed with any of the patterning processes described in greater detail above. In an embodiment, the serpentine trace 1623 is used as a component of a sensor. In Figure 16A, the serpentine trace 1623 is freestanding across the cavity 1617. However, in Figure 16B, the serpentine trace 1623 is supported from below by a dielectric layer 1624 that fills the cavity 1617.

Referring now to Figure 17, a cross-sectional illustration of an electronic system 1790 is shown, in accordance with an embodiment. In an embodiment, the electronic system 1790 comprises a board 1791, such as a PCB. In an embodiment, a package substrate is coupled to the PCB by interconnects 1792. While shown as solder balls, it is to be appreciated that any interconnect architecture may be used. In an embodiment, the package substrate comprises a glass layer 1710 and buildup layers 1735 above and/or below the glass layer 1710. In an embodiment, a structure is provided in/over the glass layer 1710. For example, a suspended layer 1721 is provided over blind cavities 1717 into the glass layer. Such an embodiment may be suitable for providing sensor type architectures for the package substrate. For example, a lid 1731 with a magnetic block 1732 may be provided over the suspended layer 1721. Other sensor architectures (such as those described in greater detail above) may also be used in the electronic system 1790. Additionally, the glass layer 1710 may comprise high aspect ratio vias that are fabricated with a bottom-up plating process in some embodiments. Other embodiments may include launcher systems embedded in the glass layer 1710.

In an embodiment, a die 1750 may be coupled to the top buildup layers 1735 by interconnects 1751. In an embodiment, the die 1750 is a processor die, an application specific die (ASIC) or the like. In embodiments with launcher systems in the glass layer, the die 1750 may be a transceiver die. In embodiments with sensing systems in the glass layer, the die 1750 may be a driver die. In other embodiments, a plurality of dies 1750 may be coupled to the buildup layers 1735.

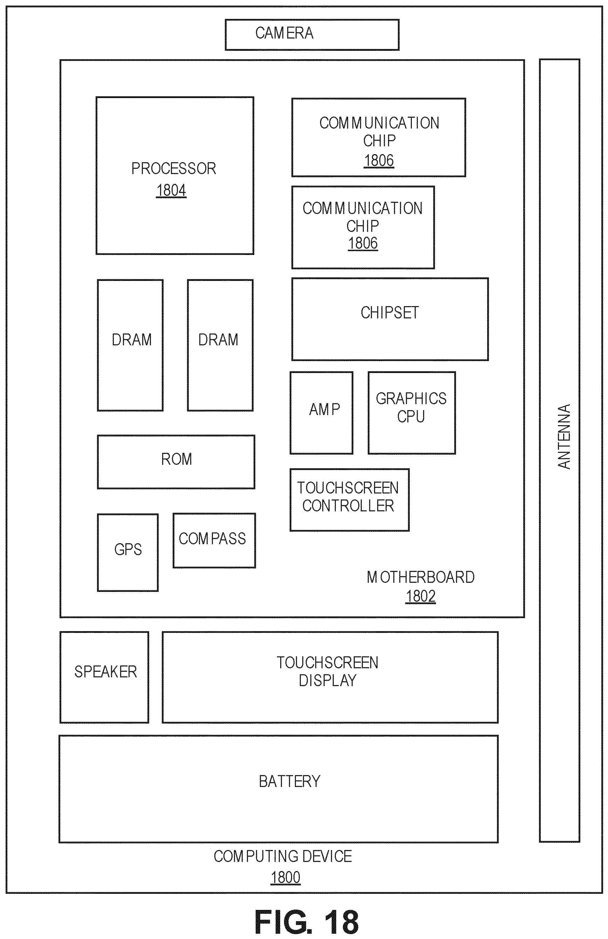

Figure 18 illustrates a computing device 1800 in accordance with one implementation of the invention. The computing device 1800 houses a board 1802. The board 1802 may include a number of components, including but not limited to a processor 1804 and at least one communication chip 1806. The processor 1804 is physically and electrically coupled to the board 1802. In some implementations the at least one communication chip 1806 is also physically and electrically coupled to the board 1802. In further implementations, the communication chip 1806 is part of the processor 1804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1806 enables wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1800 may include a plurality of communication chips 1806. For instance, a first communication chip 1806 may be dedicated to shorter range wireless communications such as Wi-Fi and Bluetooth and a second communication chip 1806 may be dedicated to longer range wireless communications such as GPS, EDGE, GPRS, CDMA, WiMAX, LTE, Ev-DO, and others.

The processor 1804 of the computing device 1800 includes an integrated circuit die packaged within the processor 1804. In some implementations of the invention, the integrated circuit die of the processor may be part of an electronic package that comprises a glass core with suspended layers over a blind cavity, bottom-up via structures, and/or mm-wave launchers, in accordance with embodiments described herein. The term "processor" may refer to any device or portion of a device that processes electronic data from registers and/or memory to transform that electronic data into other electronic data that may be stored in registers and/or memory.

The communication chip 1806 also includes an integrated circuit die packaged within the communication chip 1806. In accordance with another implementation of the invention, the integrated circuit die of the communication chip may be part of an electronic package that comprises a glass core with suspended layers over a blind cavity, bottom-up via structures, and/or mm-wave launchers, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: a core, wherein the core comprises glass; a via opening through the core, wherein the via opening has an aspect ratio (depth:width) that is approximately 5:1 or greater; and a via in the via opening, wherein the via opening is fully filled.

Example 2: the electronic package of Example 1, wherein the via does not include a seam through a center of the via.

Example 3: the electronic package of Example 1 or Example 2, wherein the via is plated up from an underlying pad.

Example 4: the electronic package of Examples 1-3, wherein the via passes entirely through a thickness of the core.

Example 5: the electronic package of Example 4, wherein the via opening has a tapered sidewall.

Example 6: the electronic package of Example 5, wherein the via opening has a first taper and a second taper that form an hourglass shaped via opening.

Example 7: the electronic package of Examples 1-6, wherein the via partially fills the via opening, and wherein a dielectric layer is disposed over the via.

Example 8: the electronic package of Example 7, further comprising: a second via over the dielectric layer, wherein the via, the dielectric layer, and the second via fully fill the via opening.

Example 9: the electronic package of Example 8, wherein the via is held at a first voltage potential, and the second via is held at a second voltage potential.

Example 10: the electronic package of Example 8 or Example 9, wherein the via, the dielectric layer, and the second via form a capacitor.

Example 11: a method of forming an electronic package, comprising: exposing a glass core with a laser to form an exposed portion of the glass core; disposing a metal layer over the glass core and the exposed portion; etching out the exposed portion from the glass core to form a via opening; and plating a via in the via opening with a bottom-up plating process.

Example 12: the method of Example 11, wherein the via opening is an hourglass shaped opening.

Example 13: the method of Example 11 or Example 12, wherein the metal layer comprises copper.

Example 14: the method of Examples 11-13, wherein the metal layer is deposited over the glass core with a cold spray process, a chemical vapor deposition (CVD) process, or a physical vapor deposition (PVD) process.

Example 15: the method of Examples 11-14, wherein the metal layer is disposed over the core before the laser exposure.

Example 16: the method of Examples 11-15, further comprising: disposing a dielectric layer over the via.

Example 17: the method of Example 16, further comprising: disposing a second via over the dielectric layer.

Example 18: an electronic system, comprising: a board; a package substrate coupled to the board, wherein the package substrate comprises: a core, wherein the core comprises glass; a via opening through the core, wherein the via opening has an aspect ratio (depth:width) that is approximately 5:1 or greater; and a via in the via opening, wherein the via opening is fully filled; and a die coupled to the package substrate.

Example 19: the electronic system of Example 18, wherein the via does not include a seam through a center of the via.

Example 20: the electronic system of Example 18 or Example 19, wherein the via opening has a tapered sidewall.

## Claims

1. An electronic package, comprising:
a core, wherein the core comprises glass;
a via opening through the core, wherein the via opening has an aspect ratio (depth:width) that is approximately 5:1 or greater; and
a via in the via opening, wherein the via opening is fully filled.

2. The electronic package of claim 1, wherein the via does not include a seam through a center of the via.

3. The electronic package of claim 1 or 2, wherein the via is plated up from an underlying pad.

4. The electronic package of claim 1, 2 or 3, wherein the via passes entirely through a thickness of the core.

5. The electronic package of claim 4, wherein the via opening has a tapered sidewall.

6. The electronic package of claim 5, wherein the via opening has a first taper and a second taper that form an hourglass shaped via opening.

7. The electronic package of claim 1, 2, 3, 4, 5 or 6, wherein the via partially fills the via opening, and wherein a dielectric layer is disposed over the via.

8. The electronic package of claim 7, further comprising:
a second via over the dielectric layer, wherein the via, the dielectric layer, and the second via fully fill the via opening.

9. The electronic package of claim 8, wherein the via is held at a first voltage potential, and the second via is held at a second voltage potential.

10. The electronic package of claim 8 or 9, wherein the via, the dielectric layer, and the second via form a capacitor.

11. A method of forming an electronic package, comprising:
exposing a glass core with a laser to form an exposed portion of the glass core;
disposing a metal layer over the glass core and the exposed portion;
etching out the exposed portion from the glass core to form a via opening; and
plating a via in the via opening with a bottom-up plating process.

12. The method of claim 11, wherein the via opening is an hourglass shaped opening.

13. The method of claim 11 or 12, wherein the metal layer comprises copper.

14. The method of claim 11, 12 or 13, wherein the metal layer is deposited over the glass core with a cold spray process, a chemical vapor deposition (CVD) process, or a physical vapor deposition (PVD) process.

15. The method of claim 11, 12, 13 or 14, wherein the metal layer is disposed over the core before the laser exposure.
